# EUROPEAN PATENT APPLICATION

(11) **EP 4 300 121 A1**
(43) Date of publication of application: **03.01.2024**
(21) Application number: 22181853.7
(22) Date of filing: 29.06.2022
(51) Int. Cl.: G01R 33/385, G01R 33/3815, G01R 33/421

(54) **MAGNETIC RESONANCE IMAGING DEVICE WITH A GRADIENT COIL ASSEMBLY**

(71) Applicant: Siemens Healthcare GmbH, 91052 Erlangen (DE)
(72) Inventor: Dietz, Peter, 90762 Fürth (DE)
(74) Representative: Siemens Healthineers Patent Attorneys

(57) **Abstract**

Magnetic resonance imaging device (1), comprising
- a superconducting main field coil assembly inside a vacuum vessel (2) of a cryogenic assembly, wherein the vacuum vessel (2) defines a cylindric patient bore (8), in which a homogeneity volume (10) of a main field created by the superconducting main field coil assembly is located, and
- a cylindrical gradient coil assembly (12) having at least one transversal gradient coil and being located inside the patient bore (8), wherein the transversal gradient coil is configured to generate a gradient field perpendicular to the longitudinal direction (9) of the patient bore (8),
wherein
- the main field coil assembly comprises multiple superconducting coils (4, 5, 6) including at least two main superconducting coils (4) located in opposing longitudinal end regions (15) of the cryogenic assembly, and
- the conductors (14) of at least the transversal gradient coils of the gradient coil assembly (12) only extend in a longitudinal conductor region (16) between the two longitudinal end regions (15).

## Description

The invention concerns a magnetic resonance imaging device, comprising
- a superconducting main field coil assembly inside a vacuum vessel of a cryogenic assembly, wherein the vacuum vessel defines a cylindric patient bore, in which a homogeneity volume of a main field created by the superconducting main field coil assembly is located, and
- a cylindrical gradient coil assembly having at least one transversal gradient coil and being located inside the patient bore, wherein the transversal gradient coil is configured to generate a gradient field perpendicular to the longitudinal direction of the patient bore.

Magnetic resonance imaging (MRI) has become an often-used tool in medical technology, in particular diagnostics. In modern magnetic resonance imaging devices, the main field (also main magnetic field B0) is generated by a superconducting main field coil assembly. To maintain the superconducting state, the superconducting main field coil assembly is located in cryogenic assembly, in particular a cryostat, of the magnetic resonance imaging device, usually comprising an outer vacuum vessel (or outer vacuum container, OVC), a thermal shield (often called cryogenic shield or, shortly, cryo-shield) and an inner cooling medium vessel or chamber comprising a cooling medium, for example helium, and the superconducting coils of the main field coil assembly.

To provide spatial resolution and for other purposes, the magnetic resonance imaging device further comprises a gradient coil assembly, which usually comprises multiple gradient coils adapted to generate a linear magnetic field gradient in a corresponding, in particular cartesian, direction. The cryogenic assembly or the vacuum vessel, respectively, define a cylindrical patient bore into which a patient can be introduced using a patient table. The gradient coil assembly is usually provided radially adjacent to the cryogenic assembly in the patient bore, wherein, inside the gradient coil assembly, a radio frequency coil assembly, for example a body coil and/or a birdcage coil, may be located.

The longitudinal axis of the patient bore is usually called the Z direction, wherein the vertical direction orthogonal to the longitudinal direction is called the Y direction and the horizontal direction orthogonal to the longitudinal direction is usually called the X direction. Gradient coil assemblies of known magnetic resonance imaging devices often have gradient coils for generating field gradients in the Z direction, the X direction, and the Y direction, respectively. The X direction and the Y direction are usually called transverse directions, such that the X gradient coil and the Y gradient coil are called transversal gradient coils.

The purpose of the gradient coils of the gradient coil assembly in magnetic resonance imaging is to produce, in particular dynamic, gradient fields in the homogeneity volume, which corresponds to the field of view of the magnetic resonance imaging device. Inevitably, the gradient coils also produce stray fields, in particular on the radially outer side of the gradient coils. Such stray fields may influence the cryogenic assembly and the superconducting main field coil assembly. In particular, the stray fields induce eddy currents in conductive material. Such eddy currents (and hence the stray fields) have two main effects. As a first effect, eddy currents produce ohmic heat, and as a second effect, eddy currents create their own magnetic fields, which may disturb magnetic resonance imaging and are hence called disturbance fields in the following.

Regarding the first effect, heat, the temperature in some regions of the cryogenic may rise, in particular where the superconducting coils of the main field coil assembly are located. If the temperature of the superconducting coils exceeds their T_{c}, a quench will occur. Regarding the second effect, magnetic field generation, any unintended magnetic field has the potential to disturb the image quality of magnetic resonance imaging. In particular, time varying disturbance fields or more complex spatial variations, in particular of higher order than one (non-linear disturbance fields) are known to cause severe issues, in particular artefacts in magnetic resonance images.

While in the pioneer days of magnetic resonance imaging, unshielded gradient coils having no active shielding layer were used, the increase of required gradient performance and the sophistication of applications require shielding measures, in particular to prevent the excessive generation of heat at the superconducting coils. To this end, actively shielded gradient coil assemblies have been proposed to reduce the amount of stray fields regarding the cryogenic assembly. For example, active shielding coils may form an additional radial layer radially outside the gradient coils, however largely increasing room required by the magnetic resonance imaging device and complicating its construction. For example, such an active shielding layer of a gradient coil assembly may have a radial extension of multiple centimeters. Here, main field creation by the superconducting main field coil assembly becomes less efficient due to larger distance from the homogeneity volume. Furthermore, current actively shielded gradient coil assemblies require a lot of additional energy, namely current and voltage supplied to the conductors of the active shielding layer. In addition, a lot of heat is generated in the conductors.

Due to these disadvantages, research currently focusses on possibilities to omit the active shielding layer by introducing new, in particular passive, shielding concepts and/or stray field controlling methods. For example, it was already proposed to use, in particular closed, electrically conductive structures around the superconducting coils to shield them from the stray fields. However, such electrically conducting structures are still subject to eddy currents caused by the stray fields in the process of shielding. The induced eddy currents produce locally strong fields counteracting the stray fields, but usually also generate eddy current fields farther away from the electrically conducting structure (shielding assembly). In the homogeneity volume, the sum of these eddy current fields may lead to disturbance fields which may massively impact the imaging quality, such that the active shielding approach discussed above has to be used.

A main source of these disturbance fields comprising image quality are the electrically conductive structures intended to shield superconducting coils. In this context, it has been proposed to design the gradient coils of the gradient coil assembly with the purpose to minimize the stray fields at the positions of the superconducting coils and/or electrically conductive structures of the shielding assembly. Here, local minimization of the stray fields by adapted gradient conductor positioning has been proposed, such that zones of low stray field strength may be created by using areas having a lower conductor density than other areas having a higher conductor density. However, these approaches have their limitations, for example due to the required linearity of the field gradients in the homogeneity volume.

Another aspect to consider is the force compensation of the gradient coils of the gradient coil assembly. Here, a mechanical force on the gradient coil during a magnetic resonance sequence, in particular during pulses, should be avoided, since vibration during imaging causes deviations in the generated fields. A main cause of the vibrations are force contributions from magnet inhomogeneities, which add up to cause net forces on a complete gradient coil assembly. Conductors in the vicinity of superconducting coils are usually causing the highest contribution to such disadvantageous net mechanical forces.

Hence, special designs have been proposed to balance these net forces, leading to further boundary conditions restricting the degrees of freedom in the design of gradient coils. Force balanced designs usually comprise gradient coil conductors at the longitudinal ends of the gradient coil, which are positioned beyond the longitudinally outermost superconducting coils. Such "force compensation conductors" cause significant stray fields affecting the cryogenic assembly, in particular shielding assemblies or the superconducting coils themselves.

It is an object of the current invention to provide an improved gradient coil design for gradient coil assemblies having no active shielding layer in a magnetic resonance device, which in particular leads to reduced stray fields in superconductors of the main field coil assembly.

This object is achieved by providing a magnetic resonance device according to claim 1. Advantageous embodiments are described by the dependent claims.

In a magnetic resonance imaging device as initially described, according to the invention,
- the main field coil assembly comprises multiple superconducting coils including at least two main superconducting coils located in opposing longitudinal end regions of the cryogenic assembly, and
- the conductors of at least the transversal gradient coils of the gradient coil assembly only extend in a longitudinal conductor region between the two longitudinal end regions.

The invention exploits the fact that in many designs of main field coil assemblies most of the superconducting material, in this case the main superconducting coils, are positioned in longitudinal end regions of the cryogenic assembly. Here, the at least two main superconducting coils in the longitudinal end regions may comprise the majority of the superconductors of the main field coil assembly. Such main superconducting coils are, however, usually also placed at the radially inner rim of the cryogenic assembly, that is, closest to the longitudinal axis of the patient bore and hence the homogeneity volume. Generally, the superconducting coils in the vacuum vessel may be arranged as multiple radial groups in different radial regions, wherein the main superconducting coils usually belong to the radially innermost group. In other words, the main field coil assembly may comprise at least two radially consecutive groups of superconducting coils, wherein the main superconducting coils are the longitudinally outermost superconducting coils of the radially innermost group.

Hence, gradient coil designs that keep the longitudinal extension of the conductor pattern very short, in particular out of the longitudinal end regions, as proposed, will not generate much stray fields on the main superconducting coils, which comprise the majority of superconductors. In other words, if the conductor pattern of the gradient coils of the gradient coil assembly ends short of the position of the main superconducting coils, less stray fields of the gradient coil assembly will affect these main superconducting coils, such that the amount of heat and generated eddy currents is significantly reduced. In addition, a gradient conductor pattern that does not extend into the longitudinal end regions and hence the vicinity of the main superconducting coils will result in less net force, such that a special force balancing can be omitted in addition to the omission of an active shielding layer of the gradient coil assembly. In other words, "force compensation conductors" are no longer required, again reducing the stray field load on the main field coil assembly.

In this context, it should be noted that the main reason for longitudinally extending the conductor patterns of the gradient coils of the gradient coil assembly, in particular the transversal gradient coils, is significantly less relevant when using a not actively shielded gradient coil assembly, as has been found in the course of the current invention. That is, the inductance of not actively shielded gradient coil assemblies are systematically reduced by about 50% compared to gradient coil assemblies having an active shielding layer. The exact value of reduction of the inductance depends on the distance between the gradient coil and the shielding coils provided by the active shielding layer. In addition, no shielding coils for generally shielding conductors have to be powered, such that less electrical energy is needed and less heat is generated in such an unshielded gradient coil assembly. Hence, the dogma according to which the region, in particular for return conductors, should be extended as much as possible, can be taken back to instead allow the design of a significantly longitudinally shorter gradient coil assembly, in particular by shortening the longitudinal extent of the transversal gradient coils generating field gradients in the transversal directions perpendicular to the longitudinal direction.

In other words, as will be further discussed below, higher thermal losses and inductance may result when shortening the longitudinal extension of the gradient coil assembly, however, omission of the active shielding layer provides room to move regarding thermal losses and inductance, which, as has been shown, does not even have to be fully exploited. The minor compromises are easily outweighed by the resulting advantages, namely no major gradient stray fields at the most relevant superconducting coil positions, leading to significantly less energy deposition and much lower eddy currents fields, which might compromise image quality, and no requirement for force compensation restricting the design freedom of the gradient coils and causing particularly high stray fields at the ends of the patient bore.

In other words, for actively shielded gradient coil assemblies, the associated disadvantages regarding heat and inductance are much less severe than the significant positive effects achieved are advantageous. Hence, it is proposed to compress the longitudinal extension of the transversal gradient coils, in particular the region of the return conductor segments, as much as possible. Here, the degrees of freedom provided by omitting an active shielding layer are exploited.

It is noted that the short gradient coil assembly may also be advantageous regarding noise generation, since a shorter assembly may be dynamically stiffer and/or may comprise less resonances in the audible frequency region and/or the amplitudes of bending vibrations may be lower.

In preferred, concrete embodiments, the conductors of the at least one transversal gradient coil comprise windings around a central turning point in a longitudinal-circumferential plane, wherein the windings comprise main conductor segments located on the longitudinal side of the turning point towards the homogeneity volume and return conductor segments on the longitudinal side of the turning point away from the homogeneity volume, wherein the density of return conductor segments is at least 90 % of, in particular at least substantially equal to, the density of main conductor segments in the longitudinal direction. The gradient conductor pattern, in particular gradient wire pattern, of a transversal gradient coil (X or Y) usually comprises two different regions, namely the region generating the relevant gradient fields, which extends from the isocenter (center of patient bore and/or homogeneity region) side to the so-called turning point (around which the windings run), and the region of so-called return conductor segments, in particular return wires, extending from the turning point towards the longitudinal end. Here, the return conductor segments have much less influence on the vital characteristics of a gradient field generated by a gradient coil than the main conductor segments in the longitudinally inner region.

Hence, preferred embodiments of the invention propose to use a high density of the return conductor segments to reduce the longitudinal extension of the transversal gradient coils and hence the gradient coil assembly. This again breaks with the dogma, as, in the state of the art, in particular for actively shielded gradient coils, design focusses on keeping the density of the return conductor segments as low as possible to reduce inductance and localized heat generation in the gradient coil. Here, however, since no active shielding layer is present in the gradient coil assembly, its inductance and also heat generation are reduced anyway, such that the minor compromises to make when increasing the conductor density do not in the least outweigh the major advantages gained.

Preferably, the longitudinal extension of the return conductor segment arrangement is at least substantially equal to or less than the longitudinal extension of the main conductor segment arrangement. If the return conductor segments are packed as densely as possible, the overall longitudinal extension of the return conductor segment arrangement (or return conductor segment pattern) can be compressed at least to the extension of the region for actual production of the gradient fields, that is, the main conductor segment arrangement (or main conductor segment pattern). In known designs, the turning point is located at, for example, 25 to 30 cm from the isocenter. In such cases, an overall longitudinal extension of the gradient coil conductor pattern for the transversal gradient coils of less than 50 cm is possible, such that the longitudinal extension of the whole gradient coil assembly may be less than 1 m. A length of less than or approximately 1 m allows to produce the stray fields of the gradient coil assembly inside the longitudinal conductor region between the two longitudinal end regions, such that no significant amount of energy is deposited in the main superconducting coils located in the longitudinal end regions.

Hence, it is generally advantageous if the longitudinal length of the gradient coil assembly is 1 m or less than 1 m. While increasing the density of return conductor segments is a preferable approach to achieve this goal, the invention also proposes other approaches to significantly shorten the length of the gradient coil assembly, which can, in preferable embodiments, be combined with the increased density of the return conductor segments to yield an optimal design. In other words, the length of the gradient coil assembly comprising conductors may be less than 1.2 m, in particular less than 1 m.

Preferably, the conductors may be wires having a width of less than 3 mm, in particular less than 2 mm, and/or a cross-sectional area of less than 10 mm². It is noted that, generally, the conductors of the gradient coils of the gradient coil assembly are preferably wires, as opposed to thin films or the like, which require a higher spatial extension in the longitudinal-circumferential plane. Here, in the state of the art, such wires usually have a cross-sectional area of more than 25 mm², in particular 30 mm² or the like, for example at extensions of 6x5 mm. It is now proposed to use smaller wire cross-sections, which significantly contribute to shortening the gradient coil assembly. However, since more current flows through a smaller cross-sectional area, significant increase in ohmic losses inside the gradient wires result, such that more heat will be produced. However, such additional heating due to higher current density is acceptable, since no heating from an active shielding layer exists and no cooling arrangements for gradient coil assemblies can handle this additional heat, which is, by the way, still smaller than the heat generated by active shielding layers. It has hence been found that the conventional, actively shielded gradient coils' limitation to try to avoid as much ohmic loss than possible no longer needs to be applied here.

This reasoning also applies to embodiments where the magnetic resonance imaging device further comprises a gradient power amplifier for providing current to the gradient coils, wherein the gradient power amplifier has a maximum output current of at least 1000 A, in particular at least 1200 A. Hence, a high current gradient power amplifier may be used, in particular in combination with small wire cross-sections and a high density of return conductor segments. The higher the current, the higher the possible current density (at smaller longitudinal extension of wires), further contributing to decreasing the longitudinal extension of the transversal gradient coils and hence the gradient coil assembly. Here, again, higher ohmic heating losses can be expected, which are, however, still lower than when using an actively shielded gradient coil assembly.

In summary, both characteristics associated with such significantly shorter designs, namely higher ohmic losses and higher inductance, are much less disadvantageous for gradient coil assemblies without active shielding layers. As heating losses are very small in not actively shielded gradient coil assemblies compared to actively shielded gradient coil assemblies, even a significant increase in ohmic losses in such an unshielded gradient coil assembly will not be limited. In particular, the not actively shielded gradient coil assembly may further comprise a cooling device designed for cooling an actively shielded, longer gradient coil assembly, which can easily handle the additionally created heat.

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: a schematical, cross-sectional view of a magnetic resonance imaging device according to the invention,
- Fig. 2: a conductor pattern of a transverse gradient coil, and
- Fig. 3: a cross-sectional view of a wire as gradient coil conductor.

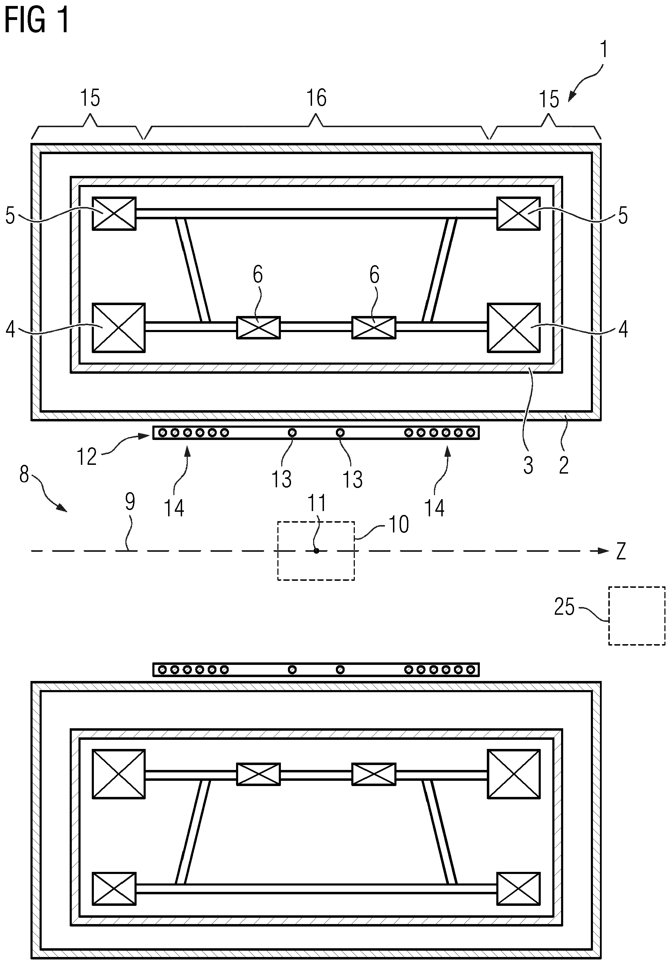

Fig. 1 is a schematical cross-sectional view of a magnetic resonance imaging device 1 in an embodiment. The magnetic resonance imaging device 1 comprises a cryogenic assembly having an outer vacuum vessel 2, a thermal shield 3 (cryo-shield) and an inner cooling medium vessel, in this case helium vessel, which is not shown in fig. 1. In the inner helium vessel, which is filled with liquid helium, superconducting coils 4, 5, 6 are supported by the support structure 7.

The outer vacuum vessel 2 defines a cylindrical patient bore 8 having a longitudinal direction 9, which is usually called Z direction. The horizontal direction orthogonal to the longitudinal direction 9 is usually called X direction, while the vertical direction orthogonal to the longitudinal direction 9 is usually called Y direction.

The superconducting coils 4, 5, 6 of the main field coil assembly generate a main field (main magnetic field, B0), in which the spins of an object to be imaged align. The main field has a certain homogeneity in a homogeneity volume 10, which forms a field of view of the magnetic resonance imaging device 1 and extends around an isocenter 11.

To allow for field gradient during imaging, in particular regarding spatially resolved measurements, a cylindrical gradient coil assembly 12 is provided inside the patient bore 8, wherein the gradient coil assembly 12 comprises three gradient coils, in particular one gradient coil to generate a field gradient in Z direction in the homogeneity volume 10 (Z coil), one gradient coil to generate a magnetic field gradient in the Y direction in the homogeneity volume 10 (Y coil) and one gradient coil to generate a magnetic field gradient in the X direction in the homogeneity volume 10 (X coil). The Y coil and the X coil are also called transversal gradient coils.

The gradient coils of the gradient coil assembly 12 are indicated by symbolic conductors 13, 14, wherein the conductors 13 are wires of the Z coil running substantially in circumferential direction and the conductors 14 are wires of the transversal gradient coils which run in a more complex pattern as discussed in more detail below.

Radially inwards from the gradient coil assembly 12, additionally, a radio frequency coil assembly may also be provided, for example a body coil and/or a birdcage coil. Such a radio frequency coil assembly (RF coil assembly) as well as other elements of the magnetic resonance imaging device 1, for example cover elements, the patient table and the like, are, for simplicity, not shown in the figures to focus onto the respective designs of the superconducting main field coil assembly and the gradient coil assembly 12.

The superconducting main field coil assembly comprises multiple superconducting coils 4, 5, 6 arranged symmetrically in pairs (two main superconducting coils 4, two superconducting coils 5 and two superconducting coils 6) regarding the longitudinal direction 9. Two radially offset groups of superconducting coils 4, 5 and 6 are shown, namely an inner radial group of superconducting coils 4 and 6 and an outer radial group of superconducting coils 5. The outer radial group is significantly farther away from the gradient coil assembly 12, such that stray fields of the gradient coil assembly 12 will be very weak, in particular negligible, such that the following considerations put lesser weight the outer radial group or even classify the superconducting coils 5 as irrelevant.

The superconducting coils 4 are main superconducting coils 4, since they comprise the majority of the superconductors of the main field coil assembly and hence generate the highest portion of the main field in the homogeneity volume 10. Such main superconducting coils 4 are usually positioned in opposing longitudinal end regions 15 of the cryogenic assembly. To reduce the amount of stray fields impacting the superconducting coils 4 (and here also 5) in the longitudinal end regions 15, the gradient coil assembly 12 has been designed such that it does not extend into the longitudinal end regions 15, but only in a longitudinal conductor region 16 between the two longitudinal end regions 15, at least concerning the conductors 13, 14. In particular, the gradient coil assembly 12 is shorter in the longitudinal direction 9 than the vacuum vessel 2, in particular by at least twice the longitudinal size of the longitudinal end regions 15. In concrete embodiments, the longitudinal extension of the gradient coil assembly 12 may be less than 1 m.

This is one of the reasons that the gradient coil assembly 12 is not actively shielded, i.e. comprises no active shielding layer. Since the extension of the conductor patterns of the gradient coil assembly 12 is very short longitudinally, it will not generate strong stray fields on the main superconducting coils 4 in the longitudinal end regions 15. Here, the conductor pattern ends short of the position of the main superconducting coils 4 such that the amount of heat deposited in the superconducting coils 4 (or a passive shielding assembly, for example at the thermal shield 3) is dramatically reduced. In addition, force balancing is not required, such that no conductors are required at far out longitudinal positions, again reducing the stray field load on the superconducting coils 4 (and 5). Generally, the stray field load onto the ends of the magnet (cryogenic assembly and main field coil assembly) is reduced, in turn decreasing the risk of image artefacts.

It is in particular noted that the discussed design works well with a segmented shielding assembly in the cryogenic assembly. While, in the past, it has been proposed to form the thermal shield 3 or other components of the cryogenic assembly completely of an electrically conducting material having a high electrical conductivity, due to the placement of the superconducting coils 4, 5, 6 longitudinally and radially extending transparency regions result, where stray fields do not meet superconducting material such that local shielding may not be necessary in such transparency regions. Hence, for example, conductive shielding rings for passively shielding at least the superconducting coils 4, 6 may be locally provided overlaying these superconducting coils 4, 6. Active shielding, however, is not required.

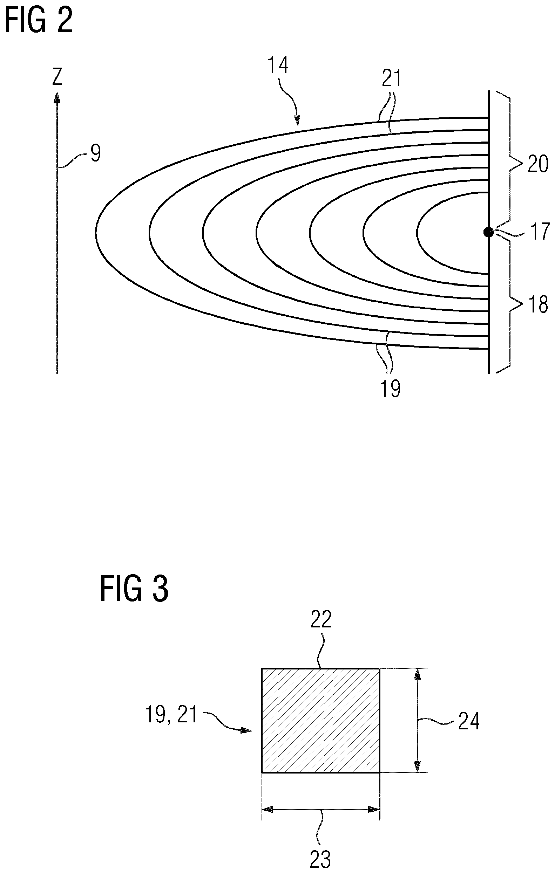

Since no active shielding layer is required, the inductance and ohmic heating of the gradient coil assembly 12 is significantly reduced, providing design freedom regarding the decrease of the longitudinal extension of gradient coil assembly 12. Here, in the embodiment of fig. 1, a high density of return conductor segments of the conductors 14 of the transversal gradient coils is implemented, as illustrated schematically in fig. 2, showing a representative portion of a conductor pattern of a transversal gradient coil of the gradient coil assembly 12. It is noted that this is purely schematical regarding the number of conductors 14 and their course.

As can be seen, the conductors 14 run around a turning point 17 in the longitudinal direction 9, wherein on the longitudinal side 18 of the turning point 17 towards the homogeneity volume 10 and isocenter 11, main conductor segments 19 extend which create the relevant gradient fields in the homogeneity volume 10. On the other side 20, towards the longitudinal end region 15, return conductor segments 21 extend, which have significantly less influence onto the shape of the gradient field in the homogeneity volume 10.

To provide for a short longitudinal extension of the gradient coil assembly 12, the return conductor segments 21 are packed as densely as possible in the longitudinal direction 9, in particular such that the conductor density of the return conductor segments 21 in the longitudinal direction 9 is equal to or even higher than the conductor density of the main conductor segments 19 in the longitudinal direction 9. Hence, the longitudinal extension of the respective main conductor segment pattern may be comparable to or even greater than the return conductor segment pattern.

Furthermore, the conductor segments 19, 21, in this case wire segments, have been designed with a small wire cross-section as shown in fig. 3, such that they can be packed even more densely. The wire 22 shown in fig. 3 has a longitudinal extension 23 of equal to or even less than 2 mm, wherein the radial extension 24 can be chosen accordingly, for example also as 2 mm. The wires 22 can be made of copper or aluminum.

Furthermore, the magnet resonance imaging device 1 comprises a gradient power amplifier 25 only schematically shown in fig. 1. The gradient power amplifier 25 is configured to provide current of up to 1200 A to the gradient coils of the gradient coil assembly 12.

While such a gradient coil assembly 12 may have a higher inductance and produce more ohmic heating than gradient coils using known conductor patterns, heating and inductance are still less than in a gradient coil assembly additionally having an active shielding layer. Hence, in particular, known cooling devices (not shown in the figures) may be applied to the gradient coil assembly 12, in particular cooling devices which have been designed/dimensioned for a gradient coil assembly having an active shielding layer. Hence, the advantages - substantially no stray fields in the main superconducting coils 4, no need for force balancing - significantly outweigh these small disadvantages. In other words, the design freedom provided by omitting the active shielding layer is utilized to provide a completely new, advantageous gradient coil design.

Although the present invention has been described in detail with reference to the preferred embodiment, the present invention is not limited by the disclosed examples from which the skilled person is able to derive other variations without departing from the scope of the invention.

## Claims

1. Magnetic resonance imaging device (1), comprising
- a superconducting main field coil assembly inside a vacuum vessel (2) of a cryogenic assembly, wherein the vacuum vessel (2) defines a cylindric patient bore (8), in which a homogeneity volume (10) of a main field created by the superconducting main field coil assembly is located, and
- a cylindrical gradient coil assembly (12) having at least one transversal gradient coil and being located inside the patient bore (8), wherein the transversal gradient coil is configured to generate a gradient field perpendicular to the longitudinal direction (9) of the patient bore (8), **characterized in that**
- the main field coil assembly comprises multiple superconducting coils (4, 5, 6) including at least two main superconducting coils (4) located in opposing longitudinal end regions (15) of the cryogenic assembly, and
- the conductors (14) of at least the transversal gradient coils of the gradient coil assembly (12) only extend in a longitudinal conductor region (16) between the two longitudinal end regions (15).

2. Magnetic resonance imaging device (1) according to claim 1, **characterized in that** the at least two main superconducting coils (4) in the longitudinal end regions (15) comprise the majority of the superconductors of the main field coil assembly.

3. Magnetic resonance imaging device (1) according to claim 1 or 2, **characterized in that** the conductors (14) of the at least one transversal gradient coil comprise windings around a central turning point (17) in a longitudinal-circumferential plane, wherein the windings comprise main conductor segments (19) located on the longitudinal side (18) of the turning point (17) towards the homogeneity volume (10) and return conductor segments (21) on the longitudinal side (20) of the turning point (17) away from the homogeneity volume (10), wherein the density of return conductor segments (21) is at least 90% of, in particular at least substantially equal to, the density of main conductor segments (19) in the longitudinal direction (9).

4. Magnetic resonance imaging device (1) according to claim 3, **characterized in that** the longitudinal extension of the return conductor segment arrangement is at least substantially equal to or less than the longitudinal extension of the main conductor segment arrangement.

5. Magnetic resonance imaging device (1) according to one of the preceding claims, **characterized in that** the length of the gradient coil assembly (12) comprising conductors (13, 14) is less than 1.2 m, in particular less than 1 m.

6. Magnetic resonance imaging device (1) according to one of the preceding claims, **characterized in that** the conductors (13, 14) are wires (22) having a width (23) of less than 3 mm, in particular less than 2 mm, and/or a cross sectional area of less than 10 mm².

7. Magnetic resonance imaging device (1) according to one of the preceding claims, **characterized in that** it further comprises a gradient power amplifier (25) for providing current to the gradient coils, wherein the gradient power amplifier (25) has a maximum output current of at least 1000 A, in particular at least 1200 A.
